# EUROPEAN PATENT APPLICATION

(11) **EP 4 815 645 A1**
(43) Date of publication of application: **30.09.2026**
(21) Application number: 25166274.8
(22) Date of filing: 26.03.2025
(51) Int. Cl.: H05K 3/46, H05K 1/03, H05K 3/00

(54) **COMPONENT CARRIER AND METHOD FOR MANUFACTURING A COMPONENT CARRIER**

(71) Applicant: AT & S Austria Technologie & Systemtechnik Aktiengesellschaft, 8700 Leoben-Hinterberg (AT)
(72) Inventor: OGGIONI, Stefano Sergio, 8700 Leoben (AT); SHIBATA, Misaki, 8700 Leoben (AT); WEIDINGER, Gerald, 8700 Leoben (AT); KIRCHHEIMER, Karl Philipp, 8700 Leoben (AT)
(74) Representative: Donatello, Daniele

(57) **Abstract**

The present invention relates to a component carrier (100) a method for manufacturing thereof, wherein the component carrier (100) comprises a stack (110) comprising a plurality of electrically conductive layer structures (104) and at least two inorganic layer structures (106). Additionally, the component carrier (100) comprises a connection structure (160) configured for connecting the at least two inorganic layer structures (106), said connection structure (160) comprising metallic nanostructures and/or microstructures (165) configured for connecting at least two of the plurality of electrically conductive layer structures (104). Furthermore, the present invention relates to a component carrier (100), wherein the component carrier (100) comprises a stack (110) comprising at least one electrically conductive layer structure (104) and at least one inorganic layer structure (106). Additionally, the component carrier (100) comprises a connection structure (160) provided on one surface of the at least one inorganic layer structure (106), said connection structure (160) comprising a material comprising a volatile portion, wherein said at least one inorganic layer structure comprises at least one venting hole (130) connected on the surface of the at least one inorganic layer structure (106) where the connection structure (160) is provided.

## Description

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, manufacturing a component carrier comprising at least two inorganic layer structures being interconnected with each other by a connection structure, may be challenging.

There may be a need to create a component carrier comprising a stack comprising at least two inorganic layer structures and a plurality of electrically conductive layer structure, and a connection structure for connecting the at least two inorganic layer structures.

In order to achieve the object defined above, a component carrier and a method of manufacturing the component carrier according to the independent claims are provided. The dependent claims describe advantageous embodiments.

### Field of the Invention

The present invention generally relates to a component carrier comprising a stack comprising a plurality of electrically conductive layer structures and at least two inorganic layer structures. Additionally, the component carrier comprises a connection structure configured for connecting the at least two inorganic layer structure, said connection structure comprising metallic nanostructures and/or microstructures configured for connecting at least two of the plurality of electrically conductive layer structures.

Further, the present invention relates to a method for manufacturing a component carrier as described.

According to a first aspect of the present invention, a component carrier is provided, wherein the component carrier comprises a stack comprising a plurality of electrically conductive layer structures and at least two inorganic layer structures. Additionally, the component carrier comprises a connection structure configured for connecting the at least two inorganic layer structures, said connection structure comprising metallic nanostructures and/or microstructures configured for connecting at least two of the plurality of electrically conductive layer structures. Preferably, the connection structure may be sandwiched between the at least two inorganic layer structures. Additionally or alternatively, the connection structure may be in direct contact with the at least two inorganic layer structures. Alternatively, the connection structure may be free from direct contact with the at least two inorganic layer structures. For example, an adhesion promotor may be arranged between the connection structure and the at least two inorganic layer structures. Further additionally or alternatively, the connection structure may be sandwiched between two of the plurality of electrically conductive layer structures and/or may be in direct contact with two of the plurality of electrically conductive layer structures. Preferably, the at least two inorganic layer structures may comprise the same material. Alternatively, the material of the at least two inorganic layer structures may be different one to each other. For example, one of the at least two inorganic layer structures may comprise glass, whereas the other of the at least two inorganic layer structures may comprise a ceramic material. Additionally or alternatively, one of the at least two inorganic layer structures may comprise solder lime glass, whereas the other of the at least two inorganic layer structures may comprise boro-silicate glass. In other words, different types of a material class, for example glass or ceramic, may be considered as different, even if they belong to a common general material class.

According to the second aspect of the present invention, a method of manufacturing a component carrier is provided, wherein the method comprises the steps of: providing a stack comprising a plurality of electrically conductive layer structure and at least two inorganic layer structure. Furthermore, the method comprises providing a connection structure configured for connecting the at least two inorganic layer structure, said connection structure comprising metallic nanostructures and/or microstructures configured for connecting at least two of the plurality of electrically conductive layer structures.

A component carrier according to the first aspect of the present invention is created, in which two inorganic layer structures are interconnected by a connection structure, said connection structures comprising metallic nanostructures and/or microstructures. This may bring the advantage that a reliable mechanical connection between the two adjacent two inorganic layer structures is provided, since the metallic nanostructures and/or microstructures may reach a total surface larger than 1 m² per gram of material. In an example, the metallic nanostructures and/or microstructures may interact with the inorganic layer structures, in particular the surface of the inorganic layer structures, for example by a mechanical interaction by a penetration of the metallic nanostructures and/or microstructures into the inorganic layer structures and/or a by physical interaction by adhesion. Additionally or alternatively, the metallic nanostructures and/or microstructures may form a reliably electrically connection between two (adjacent) of the plurality of electrically conductive layer structures. Advantageously, the metallic nanostructures and/or microstructures may at least be partially deformable and thus they may not break during manufacturing the component carrier. Additionally or alternatively, due to the deformability and/or other physical properties, the metallic nanostructures and/or microstructures may enable a reliable connection between the two (adjacent) of the plurality of electrically conductive layer structures, even if the two electrically conductive layer structures are not perfectly aligned.

In the context of the present application, the term "adjacent" may particular denote that two physical bodies and/or two layer structures are located spatially in close proximity. In an example, the two layer structures may be located laterally next to each other and/or one above the other in stacking direction. Preferably, the two adjacent layers may share a common interface with each other. Additionally or alternatively, the two adjacent layers may be locally spaced from each other, in particular being free from direct contact with each other.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components. The component carrier may be configured to transmit electromagnetic waves.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from prior art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or sapphire and/or zirconia and/or cordierite and/or cordierite and/or steatite and/or forsterite and/or yttria and/or tungsten comprising ceramic material. Additionally or alternatively, the inorganic layer structure may comprise glass/ceramic composite material and/or non-oxide based glasses and/or glass-ceramics comprising low atomic weight elements. Yet, in another example, the inorganic layer structure may comprise semi-conducting material, for example silicon and/or germanium and/or silicon oxide and/or germanium oxide and/or silicon carbide and/or gallium nitride and/or gallium arsenide and/or indium phosphide. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaO₂, AgAlO₂, LiGaTe₂, AgInSe₂, CuFeS₂, BeO.

In the context of the present application, the term "nanostructures- and/or microstructures" may particularly denote physical structures with dimensions in the range of nanometers to micrometers, in particular having dimensions in a range between 0.1 nm and 10 micrometers, more particularly in a range between 1 nm and 500 nm. Preferably, the extension/dimension of the nanostructures and/or microstructures may be related to at least one, preferably two, directions perpendicular to stacking direction. A sheet having a surface equipped with such nanostructures and/or microstructures, for instance in an ordered way (for example in rows and columns and/or defining a pattern) or in a random way, may provide specific properties in terms of adhesion with adjacent component carrier material. Depending on the material, shape, dimension, coating and arrangement of the nanostructures and/or microstructures on the sheet surface, the nanostructures and/or microstructures may have an adhesive effect (such as at a leg of a gecko) or a repellent effect (such as on a surface of a lotus flower). A sheet may have at least 100, in particular at least 1000, nanostructures and/or microstructures. For instance, a sheet with nanostructures providing an adhesive property may be converted into a sheet with nanostructures providing a non-adhesive or even repellent property by a corresponding surface coating of the nanostructures and/or microstructures (for instance with a waxy material). For instance, the nanostructures and/or microstructures may be nano- and/or microprotrusions and/or nano- and/or microindentations. Preferably, the nanostructure and/or microstructures may be nanowires, in particular copper nanowires. In an example, the nanowires may have a cylindrical shape. In another example, the nanowires may have an aspect ratio of greater then 2, in particular greater than 5, more in particular greater than 10. This means that the radial extension of the nanowires is shorter by a factor of 2, in particular 5, more in particular 10, than the axial extension of the cylindrical shaped nanowire(s). Additionally or alternatively, the nanostructures and/or microstructures may comprise metallic particles. Preferably, the metallic particles may comprise an extension between 0.1 nm and 10 micrometers in one, preferably in all, spatial directions. In an example, the nanostructures and/or microstructures may comprise a paste comprising the metallic particles, for example a sinter paste and/or solder paste.

In the context of the present application, the term "connection structure" may particular denote a physical body located between two adjacent layers. Alternatively, the connection structure may be provided, in particular in direct contact, on one surface of the at least one inorganic layer structure. The connection structure may extend over the width of the component carrier and thus may be seen as a discrete layer. Preferably, the connection structure may be a patterned layer structure. In an example, the connection structure may be patterned by the metallic nanostructures and/or microstructures. In another example, the connection structure may comprise a hole, in particular a through hole, which can be filled by the metallic nanostructures and/or microstructures. Additionally or alternatively, the connection structure may comprise organic material, for example organic polymeric material. In another example, the connection structure may be free from organic material. The connection structure may have adhesive properties. Preferably, the connection structure may be electrically insulating. Additionally or alternatively, the connection structure may be thermally insulating and/or may have dielectric properties. Optionally, the connection structure may comprise a portion comprising electrically conductive material. For example, the portion comprising electrically conductive material may extend through the entire thickness of the connection structure. Additionally or alternatively, the portion comprising electrically conductive material may comprise metallic nanostructures and/or microstructures. In an example, the portion comprising the electrically conductive material and/or the metallic nanostructures and/or microstructures may have a ratio of 1% to 80%, in particular a ratio of 5% to 50%, in comparison to the total area/volume of the connection structure.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component. Additionally or alternatively, the component may comprise a polymer waveguide and/or (optical) lenses and/or collimators and/or ferrules.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like and/or nanowires. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art. In an example, the SAP and/or mSAP may comprise acidic conditions and/or alkaline conditions.

In at least one embodiment, the at least one electrically conductive layer structure of the component carrier comprises at least one of the following group consisting of: copper, aluminum, nickel, silver, gold, palladium, molybdenum, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT) or polyaniline, respectively.

In the context of the present application, the term "electrically insulating layer structure" may denote a layer structure which is electrically non-conductive. The term "electrically insulating layer structure" is in particular used as a synonym of "organic electrically insulating layer structure" in the context of the present application.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, (hollow) spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "layer structure" may particularly denote a continuous layer, a patterned layer or a plurality of nonconsecutive islands within a common plane. A layer structure can comprise at least one protruding element such as, for example, one or more solder bumps, copper bumps, vias, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "cavity" may particularly denote a recess or hollow space having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

### Description of Exemplary Embodiments

According to a preferred embodiment of the present invention, the connection structure may comprise an inorganic connection layer structure. Preferably, the inorganic connection layer structure may comprise electrically insulating properties. Additionally or alternatively, the inorganic connection layer structure may comprise thermally insulating or thermally conductive properties. In an example, the inorganic connection layer structure may comprise silicon and/or aluminium and/or boron. Additionally or alternatively, the inorganic connection layer structure may comprise oxides and/or nitrides. Further additionally or alternatively, the inorganic connection layer structure may comprise material being different from the electrically conductive layer structure and/or may comprise a (semi)metal salt. Preferably, the inorganic connection layer structure may be different than the at least two inorganic layer structures. Alternatively, the inorganic connection layer structure may be the same as the at least two inorganic layer structures. Due to the physical and/or chemical properties of the inorganic connection layer structure, preferably being similar as the inorganic layer structure, a reliable adhesion between the inorganic layer structure and the inorganic connection layer structure may be ensured. In particular, an efficient adhesion may be achieved without the need of an adhesion promotor provided between the inorganic layer structure and the inorganic connection layer structure. Additionally or alternatively, the inorganic layer structure and the inorganic connection layer structure may comprise similar Coefficient of thermal expansion (CTE) values. This may bring the advantage of reducing the risk of de-lamination effects, a mechanical disconnection, between the inorganic layer structure and the inorganic connection layer structure and thus may ensure a reliable connection between the inorganic layer structure and the inorganic connection layer structure. Preferably, the inorganic connection layer structure may at least partially encircle the metallic nanostructures and/or microstructures. This may protect the metallic nanostructures and/or microstructures from environmental impact, for example oxidation.

According to another embodiment of the present invention, at least one, in particular the at least two, inorganic layer structures may be made of glass. In an example, the inorganic layer structure may comprise silicon base glass, in particular solder lime glass, and/or boro-silicate glass and/or alumo-silicate glass and/or lithium silicate glass and/or alkaline free glass. This may bring the advantage of imparting preferred physical properties, for example stiffness and/or coefficient of thermal expansion (CTE), to the component carrier. This may reduce the warpage behavior of the component carrier drastically compared to glass (layer)-free component carrier.

According to a further embodiment of the present invention, at least one, in particular the at least two, inorganic layer structures may comprise at least one venting hole. Preferably, the venting hole may be filled with solid and/or liquid material. The solid may comprise a surface energy creating a contact angle with a polar liquid, for example water, wherein the created contact angle between the solid and the polar liquid is higher than 60°, in particular higher than 80°. In an example, at least a channel inside the solid and/or liquid material may connect the two opposed extremities of the venting hole. In another example, the venting hole may be free from at least a channel connecting the two opposed extremities of the venting hole. Alternatively, the venting hole may be free from solid and/or liquid material. In particular, the two opposed extremities of the venting hole may be connected by each other with gas. In an example, the entire volume of the venting hole may be filled with gas. This may bring the advantage of flowing volatile and/or gaseous medium released by the involved material(s) for the stack formation and/or lamination to the environment and/or other suitable places and thus this may reduce, in particular prevent, the risk of delamination/separation effects of layer structures of the stack. Preferably, the venting hole may have a lateral and/or radial extension in the range from 1 µm to 100 µm, in particular in the range from 5 µm to 30 µm. Additionally or alternatively, the vertical through connection may have a lateral and/or radial extension in the range from 100 µm to 300 µm.

In the context of the present application, the term "venting hole" may particular denote an opening and/or recess in a layer structure, in particular an inorganic layer structure and/or an electrically insulating layer structure. The venting hole may extend through the entire thickness of the layer structure in which it is provided. Additionally or alternatively, the venting hole may be configured to allow the flowing of volatile and/or gaseous medium, in particular to the environment. The volatile and/or gaseous material may be released during at least one manufacturing step, for example a lamination step and/or a pressing step, preferably when the connection structure cures and/or hardens. Additionally or alternatively, the volatile and/or gaseous material may be released, preferably from the connection structure, over the time without exposure to a manufacturing step.

According to a preferred embodiment of the present invention, the metallic nanostructures and/or microstructures may comprise nanowires and/or a conductive paste, in particular a sinter paste and/or solder paste. Preferably, the conductive paste may comprise metallic particles. Additionally or alternatively, the conductive paste may comprise particles having an extension in the range from 1 nm to 10 µm. This may bring the advantage of reliably mechanically and/or electrically connect the at least two of the plurality of electrically conductive layer structures. In particular, the plurality of nanowires in direct contact with each other and/or intermingled with each other may ensure a high quality electric current and/or electric signal transmission. Additionally or alternatively, providing nanowires and/or a conductive paste is an easy way to create a connection structure, even in case of coarse connections alignment tolerances during and after (for example for CTE reasons) the stack formation.

According to another embodiment of the present invention, the connection structure, in particular the inorganic connection layer structure, may comprise meta silicate, in particular lithium and/or potassium meta silicate. Additionally or alternatively, connection structure may comprise other derivatives of the silicate, for example ortho silicates, and/or sodium meta silicate and/or alkali meta silicate. This may bring the advantage of forming a reliable connection with the inorganic layer structure in particular glass. Additionally or alternatively, the connection between the inorganic layer structure and the meta silicate comprising connection structure may be gas tight and/or liquid tight. Further additionally or alternatively, the connection structure comprising meta silicate may reduce or prevent (metal) ion migration, in particular copper migration, resulting in a reliable long-life performance of the component carrier.

According to a further embodiment of the present invention, the connection structure may be in direct contact with at least one of the plurality of electrically conductive layer structures. Preferably, the metallic nanostructures and/or microstructures may be in direct contact with at least one of the plurality of electrically conductive layer structures. Additionally or alternatively, the connection structure, in particular the nanostructures and/or microstructures may merge from at least one of the plurality of electrically conductive layer structures. Further additionally or alternatively, the connection structure, in particular the nanostructures and/or microstructures, may (monolithically) grow from the surface of the at least one of the plurality electrically conductive layer structures. This may bring the advantage of having a strong mechanical connection between the connection structure and the at least one of the plurality electrically conductive layer structures.

According to a preferred embodiment of the present invention, at least one of the plurality of electrically conductive layer structures may be connected to the metallic nanostructures and/or microstructures. Preferably, two of the plurality of electrically conductive layer structures may be connected to (the same) metallic nanostructures and/or microstructures. Since the metallic nanostructures and/or microstructures may comprise at least hundreds of individual metallic structures creating distinct and/or discrete electrically conductive tracks, even if one of the metallic nanostructures and/or microstructures is not connected to one of the plurality of electrically conductive layer structures, the others of the metallic nanostructures and/or microstructures may be connected to the at least one of the plurality of electrically conductive layer structures and thus a reliable electrical connection may be ensured.

According to another embodiment of the present invention, the plurality of electrically conductive layer structures may comprise at least one, in particular a plurality of, vertical through connections passing through the entire thickness of the one of the at least two inorganic layer structures. In an example, the at least one vertical through connection may comprise a metal, in particular copper, filled hole and/or recess. Preferably, the hole and/or recess may be fully filled by the metal. Additionally or alternatively, the hole and/or recess may at least partially filled by the metal. The hole and/or recess may be manufactured by a mechanical drilling process and/or a laser drilling process and/or an etching process. In an example, the vertical through connection may comprise inclined sidewalls in regard to stacking direction. In another example, the vertical through connection may comprise sidewalls being parallel to stacking direction. Preferably, the vertical through connection may have a lateral and/or radial extension in the range from 30 µm to 150 µm, in particular in the range from 50 µm to 100 µm. Additionally or alternatively, the vertical through connection may have a lateral and/or radial extension in the range from 150 µm to 300 µm. Preferably, the (lateral) extension of the vertical through connection may be the same or different, in particular bigger, than the (lateral) extension of the venting hole (e.g. enough for the volatile portion passage). In an example the venting hole may have a lateral extension of 10 µm, whereas the vertical through connection may have a lateral extension of 80 µm.

This may create an electrical connection passing through the thickness of the one of the at least two inorganic layer structure and thus may connect the exposed and/or opposed surfaces of the at least two inorganic layer structures to the other surface of the at one of the at least two inorganic layer structures.

According to a further embodiment of the present invention, each of the at least two inorganic layer structures comprises at least one, in particular a plurality of, vertical through connections passing through the entire thickness of the respective inorganic layer structures, in particular the plurality of vertical through connections passing through one first inorganic layer structure may be misaligned with the respective vertical through connections passing through the other second inorganic layer structure in regard to at least one direction, in particular in regard to stacking direction and/or perpendicular to stacking direction. Preferably, the misalignment of the vertical through connection of the first inorganic layer structure in regard to the vertical through connection of the second inorganic layer structure may be in the range from 0.5 µm to 30 µm. Additionally or alternatively, the misalignment of the vertical through connection of the first inorganic layer structure in regard to the vertical through connection of the second inorganic layer structure may be in the range from 30 µm to 1000 µm. Further additionally or alternatively, at least one vertical through connection passing through one first inorganic layer structure may be aligned with another respective vertical through connection passing through the other second inorganic layer structure in regard to at least one direction, in particular in regard to stacking direction. This may bring the advantage of having a high design flexibility. Additionally or alternatively, this may bring the possibility of spreading heat over a bigger spatial volume and thus ensuring an efficient heat management. Preferably, the vertical through connection passing through one first inorganic layer structure may be connected to the vertical through connection passing through the other second inorganic layer structure, in particular by the connection structure and/or by the metallic nanostructures and/or microstructures. This may create a reliable electrical connection between the vertical through connection passing through one first inorganic layer structure and the vertical through connection passing through one second inorganic layer structure.

According to a preferred embodiment of the present invention, the amount of vertical through connections passing through the first inorganic layer structure may be different than the amount of vertical through connections passing through the second inorganic layer structure. Alternatively, the amount of vertical through connections passing through the first inorganic layer structure may be the same as the amount of vertical through connections passing through the second inorganic layer structure. This may bring the advantage of creating a redistribution layer structure within the two adjacent inorganic layer structures.

According to another embodiment of the present invention, the extension of the vertical through connection passing through the first inorganic layer structure may be different than the extension of the vertical through connection passing through the second inorganic layer structure. In an example, the radial and/or lateral extension of the vertical through connection passing through the first inorganic layer structure may be different than the radial and/or lateral extension the of the vertical through connection passing through the second inorganic layer structure. In another example, the axial extension and/or the extension in stacking direction of the vertical through connection passing through the first inorganic layer structure may be different than the axial extension and/or the extension in stacking direction the of the vertical through connection passing through the second inorganic layer structure. Additionally or alternatively, the extension of the vertical through connection passing through the first inorganic layer structure may be the same as the extension of the vertical through connection passing through the second inorganic layer structure. Larger extensions of the vertical through connections may efficiently transmit high power and/or heat, whereas smaller extensions of the vertical through connections may efficiently transmit electrical signals.

According to a further embodiment of the present invention, at least one of the plurality of electrically conductive layer structures may comprise an element of an antenna structure and/or may form an antenna structure. In an example, a component of an antenna structure may be a portion of a stripline and/or a feeding line. Additionally or alternatively, at least one of the at least two electrically conductive layer structures may form a patch antenna and/or a slot antenna. This may bring the advantage of imparting an electromagnetic transmitting and/or receiving function to the component carrier.

According to a preferred embodiment of the present invention, at least one of the plurality, in particular of the at least two of the plurality of electrically conductive layer structures may comprise a stripline.

According to another embodiment of the present invention, at least one of the plurality, in particular at least two of the plurality, of the electrically conductive layer structures may comprise a roughness Ra smaller than 5 µm. Additionally or alternatively, at least one of the plurality, in particular at least two of the plurality, of the electrically conductive layer structures comprises a roughness Ra in the range from 500 nm to 10 µm, in particular in the range from 600 nm to 5 µm. This may be a result from a polishing step and/or from a galvanic process step. Preferably, an electrically conductive layer structure comprising a roughness Ra smaller than 5 µm may be transmit electrical signals and/or electromagnetic waves with low losses.

According to a further embodiment of the present invention, the stack may comprise a shielding structure. The shielding structure may be a constituent of at least one electrically conductive layer structure. Optionally, the shielding structure may comprise at least one of the plurality of the electrically conductive layer structure. Additionally or alternatively, the shielding structure may comprise an inorganic layer structure, in particular one of the at least two inorganic layer structure, and/or the shielding structure may comprise organic polymeric material. The shielding structure may be configured to shield electromagnetic waves, for example such as a Faraday cage, and/or thermal energy. The shielding structure may be electrically and/or thermal conductive.

According to a preferred embodiment of the present invention, at least one of the plurality of electrically conductive layer structures may comprise and/or may form the shielding structure. In an example, the at least one of the plurality of electrically conductive layer structures may be a copper trace and/or a metal filled via. Additionally or alternatively, the at least one of the plurality of electrically conductive layer structures may be structured and/or comprises at least two portions. This may bring the advantage of manufacturing to shielding structure without an additional process step during the manufacture of the component carrier, for example by an etching step and/or a galvanic step. This may ensure an accurate creation of the shape of the shielding structure.

According to another embodiment of the present invention, the shielding structure may be located on one surface of one of the at least two inorganic layer structures. In other words, the shielding structure may be in direct contact with one of the at least two inorganic layer structures. Additionally or alternatively, the shielding structure may be free from direct contact of one of the at least two inorganic layer structures. In an example, an adhesive material and/or an organic material may be provided between the shielding structure and the one of the at least two inorganic layer structures. This may simplify the manufacturing process since the one of the at least two inorganic layer structures may be cladded by an electrically conductive layer structure and an etching process may form a shielding structure on one surface of the inorganic layer structure.

According to a further embodiment of the present invention, the shielding structure may be located on the opposed surface of at least one, in particular on both, of the inorganic layer structure where the connection structure is provided. Additionally or alternatively, the shielding structure may be located on the same surface of at least one, in particular on both, of the inorganic layer structure where the connection structure is provided. This may bring the advantage of separating the stack into a spatial portion of being shielded and a spatial portion not being shielded. The separation boarder may be the inorganic layer structure and/or the connection structure. This may reduce the signal losses since an antenna structure is in close proximity to the shielding structure.

According to a preferred embodiment of the present invention, the shielding structure may be free from direct contact with the connection structure. In an example, the shielding structure may be separated from the connection structure by an additional material or an additional layer structure. For example, the additional material or the additional layer structure may be an adhesive material or an adhesive layer structure. Additionally the shielding structure may be embedded in the inorganic layer structure and thus the shielding structure is free from direct contact with the connection structure. This may bring the advantage of efficiently exploit the volume of the stack and thus may miniaturize the overall extension of the component carrier.

According to another embodiment of the present invention, at least one of the at least two inorganic layer structures may comprise the shielding structure. In an example, the first inorganic layer structure may comprise an electromagnetic shielding and the second inorganic layer structure may comprise a thermal shielding. Additionally or alternatively, the first inorganic layer structure and the second inorganic layer structure may comprise an electromagnetic shielding or a thermal shielding. This may bring the advantage of creating separated shielding portions in the stack. Additionally or alternatively, this may bring the advantage of creating a portion shielding the stack from electromagnetic waves and another portion shielding the stack from thermal energy.

According to a preferred embodiment of the present invention, the (element of the) antenna structure may be associated to the same inorganic layer structure as the shielding structure. Preferably, the shielding structured may be located on one side of the inorganic layer structure, whereas the (element of the) antenna structure is located on the opposed other side of the inorganic layer structure. Additionally or alternatively, the (element of the) antenna structure may be located on the same vertical level in regard to stacking direction as the shielding structure. This may bring the advantage of providing the (element of the) antenna structure and the shielding structure may be in closed proximity one to each other and thus may enhance the shielding efficiency of the shielding structure in regard to the (element of the) antenna structure.

In the context of the present application, the term "associated" may mean that two things are related with another, in particular connected to another or in contact with each other. In an example, the (element of the) antenna structure and/or the shielding structure may be in direct contact with the (same) inorganic layer structure. In another example, the (element of the) antenna structure and/or the shielding structure may be in indirect contact with the (same) inorganic layer structure. An adhesive material may be provided between the (element of the) antenna structure and the inorganic layer structure and/or an adhesive material may be provided between the shielding structure and the inorganic layer structure. Preferably, the (element of the) antenna structure may be free from contact to shielding structure.

According to a further embodiment of the present invention, the component carrier may comprise at least one component. In an example, the at least one component may be embedded in the stack, in particular in one of the at least two inorganic layer structures. In another example, the component may be at least one component may be provided on the surface on the stack. This may enlarge the functionality of the stack.

In context of the present application, the term "embedding" may particularly denote that the component is in direct contact with an electrically insulating material originated from at least one electrically insulating layer structure and/or the at least one further layer structure. In an example, the electrically insulating material may be an encapsulant material. Preferably, at least one surface of the component may be in direct contact with the electrically insulating material. In particular, the term "fully embedding" may mean that at least three surfaces of a component are in direct contact with the electrically insulating material when considering a cross-sectional view. Preferably, one main surface of the component and two sidewalls of the component may be in direct contact with the electrically insulating material. More preferably, the at least three surfaces of the component may be fully covered by the electrically insulating material. Optionally, at least a portion of a fourth surface of the component may be in direction contact with the electrically insulating material. Further optionally, at least one connecting surface or connecting terminal of the component may be in direct contact with the electrically insulating material. In an example, the term embedding may also include that at least one surface of the mold material at least partially encapsulating the component may be in direct contact with the electrically insulating material.

According to a preferred embodiment of the present invention, the at least one component may be provided in a cavity located in at least one of the at least two inorganic layer structures. In an example, a plurality of components may be provided in the same cavity located in at least one of the at least two inorganic layer structures. Additionally or alternatively, only one component may be provided in a cavity located in at least one of the at least two inorganic layer structures. Preferably, the at least one component may be fully embedded in the stack, in particular in at least one of the at least two inorganic layer structures. This may bring the advantage of physically and/or mechanically protecting the component from the environment.

According to another embodiment of the present invention, the at least one component may be connected to the antenna structure. Preferably, the at least one component may be (directly) connected to the antenna structure by the at least one of the plurality of electrically conductive layer structures. Additionally or alternatively, the at least one component may be (directly) connected to the antenna structure by the metallic nanostructures and/or microstructures. The connection by the at least one of the plurality of electrically conductive layer structures and/or the metallic nanostructures and/or microstructures may have a low electrical resistance, for example smaller than 10⁻⁵ Ω/m, the electrical signal transmitted between the at least one component and the antenna structure comprise low losses.

According to a further embodiment of the present invention, the cavity may comprise the shielding structure. The shielding structure may be provided at the circumference of the cavity, for example as a shielding layer. Additionally or alternatively, the shielding structure may be a portion of the volume of the cavity. Further additionally or alternatively, the shielding structure may fully fill a cavity. By providing the shielding structure in a cavity, the volume of the stack may be effectively exploit and thus this may help the miniaturize the component carrier.

According to a preferred embodiment of the present invention, the at least two of the plurality of electrically conductive layer structures, the at least two inorganic layer structures, the connection structure and the metallic nanostructures and/or microstructures may form a core structure, in particular an inorganic core structure, more in particular an inorganic multilayer core structure. Preferably, the (inorganic multilayer) core structure may comprise physical properties being different than the physical properties of the respective constituents. Nevertheless, the (inorganic multilayer) core structure may comprise a stiffness, which is able to efficiently reduce, in particular prevent, warpage behavior of the stack. The (inorganic multilayer) core structure may be configured as a stiffener structure. Additionally or alternatively, the (inorganic multilayer) core structure may be configured as a carrier structure.

According to another embodiment of the present invention, the stack may comprise at least one electrically insulating layer structure, in particular at least one organic electrically insulating layer structure.

According to a further embodiment of the present invention, at least one, in particular a plurality, of electrically insulating layer structures may be located on one side of one of the at least two inorganic layer structures, in particular of the core structure.

According to a preferred embodiment of the present invention, another at least one, in particular a plurality, of electrically insulating layer structures may be located on the other side of one of the at least two inorganic layer structures, in particular of the core structure. Additionally or alternatively, at least one, in particular a plurality, of electrically insulating layer structures and/or at least one, in particular a plurality, of the other electrically insulating layer structures may be located between the at least two inorganic layer structures. This may bring the advantage modifying the stack and imparting different physical and/or chemical properties to the stack.

According to another embodiment of the present invention, at least one, in particular a plurality, of further electrically conductive layer structures may be located at one main surface of at least one of the at least two inorganic layer structures, in particular of the core structure, in particular in contact with at least one of the plurality of electrically insulating layer structures and/or the other plurality of electrically insulating layer structures. Preferably, the plurality of further electrically conductive layer structures may be vertically interconnected with each other by electrically conductive vertical interconnections in regard to stacking direction. The electrically conductive vertical interconnection may comprise metal, in particular copper.

According to a further embodiment of the present invention, at least one of the plurality of further electrically conductive layer structures may be provided between two of the plurality of electrically insulating layer structures and/or
at least one of the plurality of further electrically conductive layer structures is provided between two of the other plurality of electrically insulating layer structures. This may bring the advantage of providing a further electrically conductive layer structures outside the at least two inorganic layer structures and/or the core structure, being interconnected with each other. Additionally or alternatively, this may bring the advantage of providing a high copper density outside the inorganic core structure.

According to a preferred embodiment of the present invention, the plurality of further electrically conductive layer structures and the plurality of electrically insulating layer structures may form a redistribution layer structure.

According to another embodiment of the present invention, the plurality of further electrically conductive layer structures and the other plurality of electrically insulating layer structures may form a second redistribution structure provided at the opposed main surfaces of the at least two inorganic layer structures, in particular of the core structure. This may bring the advantage of modifying the copper density in several layers and thus may adjust the electrically conductive layer structure to be connected to connection terminals/surfaces of electronic components.

According to a further embodiment of the present invention, the two redistribution structures may be configured to impart to the component carrier an asymmetric structure. Preferably, the two redistribution (layer) structures may comprise a different amount of electrically insulating layer structures and/or a different amount of further electrically conductive layer structures with respect one to each other. Additionally or alternatively, the two redistribution (layer) structures may comprise a different total thickness one to each other and/or the thickness of one of the further electrically conductive layer structures of the first redistribution (layer) structure may be different than the thickness of one of the further electrically conductive layer structures of the second redistribution (layer) structure and/or the thickness of one of the electrically insulating layer structures of the first redistribution (layer) structure may be different than the thickness of one of the electrically insulating layer structures of the second redistribution (layer) structure. This may bring the advantage of creating a surface of the stack being configured to be connected to a mother board, whereas the opposed surface of the stack may be configured to be connected to at least one active component. Due to the connection of the two redistribution structures to the inorganic core structure, an undesirable warpage of the stack can be prevented, since the inorganic core structure may impart a stiffness to the stack which compensates the warpage behavior of the asymmetrical redistribution layer structures.

According to a preferred embodiment of the present invention, the amount of further electrically conductive layer structures, which are in contact with at least one of the plurality of electrically insulating layer structures may be different than the amount of further electrically conductive layer structures, which are in contact with at least one of the plurality of the other electrically insulating layer structures. Alternatively, the amount of further electrically conductive layer structures, which are in contact with at least one of the plurality of electrically insulating layer structures may be the same as the amount of further electrically conductive layer structures, which are in contact with at least one of the plurality of the other electrically insulating layer structures. In an example, the amount of further electrically conductive layer structures, which are in contact with at least one of the plurality of electrically insulating layer structures may be larger than three layers, whereas the amount of further electrically conductive layer structures, which are in contact with at least one of the plurality of the other electrically insulating layer structures is larger than two layers. This may bring the advantage of controlling the warpage behavior of the stack.

According to another embodiment of the present invention, the further electrically conductive layer structure may be connected to the electrically conductive layer structure. In an example the connection between the further electrically conductive layer structure and the electrically conductive layer structure may comprise a vertical through connection and/or metallic nanostructures and/or microstructures. This may bring the advantage of connecting the exposed surface of the stack with a component embedded in one inorganic layer structure.

According to a further embodiment of the present invention, the component carrier may comprise at least one further component.

According to a preferred embodiment of the present invention, the at least one further component may be provided at one main surface of the stack.

Preferably, the further component may be different than the component. For example, the component may be a transistor, whereas the further component may be a sensor. Additionally or alternatively, the component and the further component may be the same. In an example, the further component may be at least partially embedded in the stack. In another example, the further component may be at least partially covered by a molding material. This may enlarge the functionality of the component carrier. Additionally or alternatively, the further component may be mechanically and/or chemically protected from the environment.

According to another embodiment of the present invention, the at least one further component may be connected to the further electrically conductive layer structure. This may ensure that the further component may be reliably connected to electric current supply and/or that the further component may be electrically connected to the component.

According to a further embodiment of the present invention, the method of manufacturing the component carrier may comprise the step of providing an inorganic connection layer structure. This may include a wet chemical process step. For example, the inorganic connection layer structure may be provided on one main surface of at least one of the at least two inorganic layer structures. This process step may ensure that the metallic nanostructures and/or microstructures are at least partially encircled by the inorganic connection layer structures. Additionally or alternatively, the inorganic connection layer structure may be provided between the metallic nanostructures and/or microstructures.

According to a preferred embodiment of the present invention, the method of manufacturing the component carrier may comprise the step of connecting the first inorganic layer structure to the second inorganic layer structure by the connection structure.

According to another embodiment of the present invention, the method of manufacturing the component carrier may comprise the step of connecting the first inorganic layer structure to the second inorganic layer structure by metallic nanostructures and/or microstructures.

Additionally or alternatively, the first inorganic layer structure and the second inorganic layer structure may be connected by the inorganic layer connection layer structure. This may ensure a reliable mechanical and/or electrical connection between the two (adjacent) inorganic layer structures. Additionally or alternatively, the may ensure a void free and/or fluid tight connection between the two (adjacent) inorganic layer structures.

According to a further embodiment of the present invention, the method of manufacturing the component carrier may comprise the step of providing at least one venting hole in at least one inorganic layer structure, in particular by a material removal process. Preferably, the material removal process may comprise a mechanical drilling process step and/or a laser drilling process step. Additionally or alternatively, the material removal process may comprise an etching step, in particular a wet chemical etching step and/or a plasma etching step. This may bring the advantage of creating a venting hole having a precisely shaped form and/or outer contour.

According to the third aspect of the present invention, a component carrier is provided, wherein the component carrier comprises a stack comprising at least one electrically conductive layer structure and at least one inorganic layer structure. Additionally, the component carrier comprises a connection structure provided on one surface of the at least one inorganic layer structure, said connection structure comprising a material suitable to have contained a volatile portion, wherein said at least one inorganic layer structure comprises at least one venting hole connected on the surface of the at least one inorganic layer structure where the connection structure is provided. Preferably, the volatile portion may be released during the hardening of the material and/or during a manufacturing step. Additionally or alternatively, the volatile portion may be released to the environment. In an example, the volatile portion may comprise volatile and/or gaseous material. This may bring the advantage of ensuring a good adhesion between the connection structure and the inorganic layer structure since the volatile portion can be released and may not build up pressure at the interface between the connection structure and the inorganic layer structure resulting in no delamination event. In an example, the venting hole may be provided in the inorganic layer structure and the at least one electrically conductive layer structure.

According to an embodiment of the present invention, the venting hole may have a lateral and/or radial extension being different, in particular smaller, than the lateral and/or radial extension of the vertical through connection passing through the entire thickness of one of the at least two inorganic layer structure. Preferably, the venting hole and the vertical through connection may be provided at the same inorganic layer structure. Additionally or alternatively, the venting hole may have a lateral and/or radial extension being the same as the lateral and/or radial extension of the vertical through connection passing through the entire thickness of one of the at least two inorganic layer structure. In an example the lateral and/or radial extension of the venting hole may be in the range from 3 µm to 15 µm, preferably smaller than 10 µm. This may prevent liquid material to pass through the venting hole, whereas vapor and/or gas can pass through.

According to a preferred embodiment of the present invention, the venting hole may be filled, in particular fully filled, by the connection structure, in particular the meta silicate, and/or the electrically insulating layer structure. In an example, one extremity of the venting hole may be filled by the connection structure and the other extremity of the venting hole may be filled by the electrically insulating layer structure. In another example, the venting hole may be fully filled by the connection structure. In a further example, the venting hole may be fully filled be the electrically insulating layer structure. This may enhance the mechanical stability of the stack, since the material protruded into the venting hole may function as a barb.

According to an embodiment of the present invention, the venting hole may comprise a sidewall being delimited by the at least one electrically conductive layer structure and the inorganic layer structure. According to a further embodiment of the present invention, the sidewall of the venting hole may comprise at least two portions, in particular a first portion extending parallel to stacking direction and a second portion being inclined to stacking direction. According to a preferred embodiment of the present invention, the sidewall of the venting hole may comprise a stepped portion, in particular the stepped portion may be located at the extremity of the venting hole. This may bring the advantage of providing a high surface area to interact with the (material of the) connection structure and/or the (material of the) at least one electrically insulating layer structure. This may result in good adhesion between the inorganic layer structure and the connection structure and/or the electrically insulating layer structure.

The preferred embodiments presented with reference to a component carrier according to the first aspect of the present invention and its advantages apply correspondingly to a method according to the second aspect of the present invention.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.
Figure 1 to Figure 11 illustrate cross-sectional views of structures obtained during carrying out a method of manufacturing a component carrier according to an exemplary embodiment of the invention.
Figure 1 illustrate a cross-sectional view of an inorganic layer structure according to an exemplary embodiment of the invention.
Figure 2 illustrate a cross-sectional view of an inorganic layer structure according to an exemplary embodiment of the invention.
Figure 3 illustrate a cross-sectional view of an inorganic layer structure according to an exemplary embodiment of the invention.
Figure 4 illustrate a cross-sectional view of a precursor or an element of a component carrier according to an exemplary embodiment of the invention.
Figure 5 illustrate a cross-sectional view of a precursor or an element of a component carrier according to an exemplary embodiment of the invention.
Figure 6 illustrate a cross-sectional view of a precursor or an element of a component carrier according to an exemplary embodiment of the invention.
Figure 7 illustrate a cross-sectional view of a precursor or an element of a component carrier according to an exemplary embodiment of the invention.
Figure 8 illustrate a cross-sectional view of a precursor or an element of a component carrier according to an exemplary embodiment of the invention.
Figure 9 illustrate a cross-sectional view of a component carrier according to an exemplary embodiment of the invention.
Figure 10 illustrate a cross-sectional view of a component carrier according to an exemplary embodiment of the invention.
Figure 11 illustrate a cross-sectional view of a component carrier according to an exemplary embodiment of the invention.
Figure 12 illustrate a cross-sectional view of a component carrier according to an exemplary embodiment of the invention.

### Detailed Description

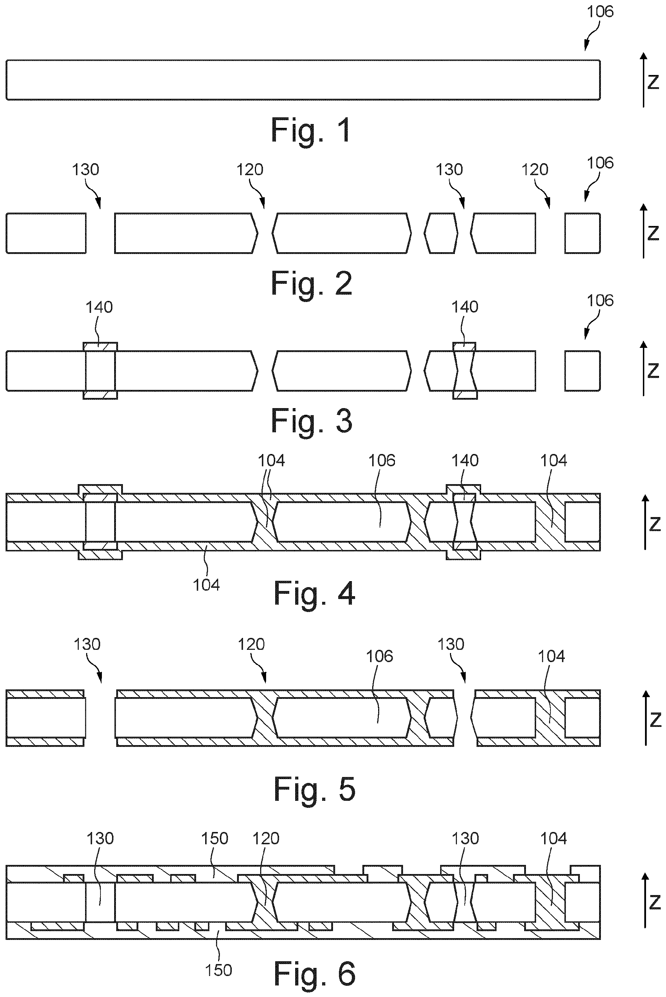

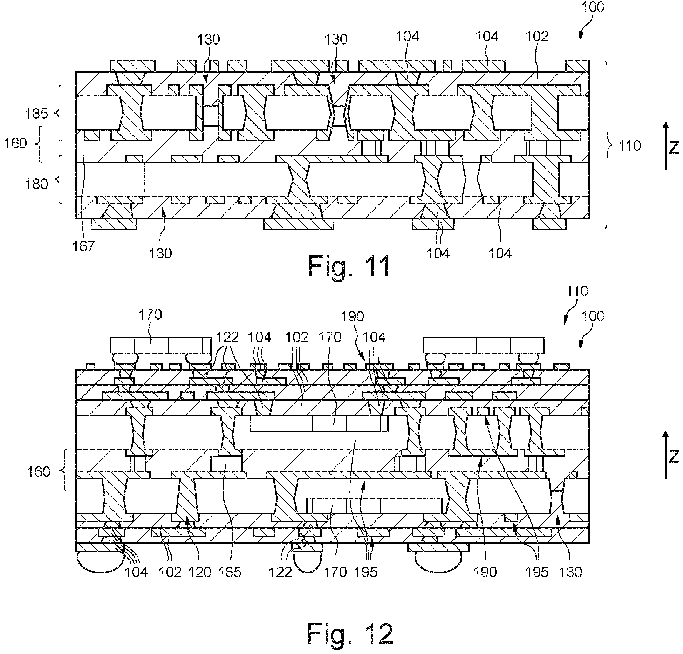

A component carrier 100, for example as shown in Figure 11 or similar, can be manufactured by a combination of the explained process steps described in Figure 1 to Figure 11.

Figure 1 shows a cross-sectional view of an inorganic layer structure 106 as an exemplary embodiment of the present invention. The inorganic layer structure 106 may be a glass plate or a glass core. Additionally or alternatively, the inorganic layer structure may comprise ceramic material. In the shown Figure 1, the main surfaces located on opposed sites of the inorganic layer structure 106 in regard to stacking direction Z are free from electrically conductive material, for example metal such as copper. Alternatively, the inorganic layer structure 106 may comprise electrically conductive layer structures, for example a copper cladded glass core (not shown).

Figure 2 shows a cross-sectional view of an inorganic layer structure 106 as an exemplary embodiment of the present invention. In addition to Figure 1, the inorganic layer structure 106 comprises openings extending from the first main surface to the second main surface of the inorganic layer structure 106 in regard to stacking direction Z. At least one of the openings may form a vertical through connection 120. Additionally or alternatively, at least one of the openings may form a venting hole 130. The vertical through connection 120 and/or the venting hole 130 comprises sidewalls having an extension direction being parallel to stacking direction Z. Additionally or alternatively, the vertical through connection 120 and/or the venting hole 130 comprises sidewalls having an extension direction being inclined to stacking direction Z. In an example, the vertical through connection 120 and/or the venting hole 130 may have a rectangular and/or cylindrical shape. Additionally or alternatively, the vertical through connection 120 and/or the venting hole 130 may have an hour-glass like shape. In another example, the lateral and/or radial extension of the venting hole 130 may be the same as the lateral and/or radial extension of the vertical through connection 120. Additionally or alternatively, the lateral and/or radial extension of the venting hole 130 may be the different, in particular smaller, than the lateral and/or radial extension of the vertical through connection 120. The vertical through connections 120 and/or the venting holes 130 may be formed by a drilling process step, for example laser drilling. Additionally or alternatively, the vertical through connections 120 and/or the venting holes 130 may be formed by an etching process step, for example plasma etching and/or a wet chemical etching process step, preferably using hydrofluoric acid.

Figure 3 shows a cross-sectional view of an inorganic layer structure 106 as an exemplary embodiment of the present invention. In addition to Figure 2, the inorganic layer structure 106 comprises a temporary mask 140. The temporary mask 140 is provided on the two opposed main surfaces of the inorganic layer structure 106. Preferably, the temporary mask 140 is in direct contact with the inorganic layer structure 106. Additionally or alternatively, the temporary mask 140 fully covers at least one venting hole 130. The temporary mask 140 may comprise an organic polymeric material, for example a resin material. Additionally or alternatively, the temporary mask 140 may be configured to seal the venting hole 130 from the environment and/or may be configured to hinder, in particular prevent, material, in particular an electrically conductive layer structure 104, to protrude into the venting hole 130. Preferably, the lateral extension of the temporary mask 140 may be bigger than the (largest) lateral extension of the venting hole 130. The temporary mask 140 may be provided by a lamination process step followed by a structuring step. Additionally or alternatively, the temporary mask 140 may be provided by a printing step and/or a dispensing step. Preferably, the temporary mask 140 may not cover the vertical through connection 120. Additionally or alternatively, the temporary mask 140 may be provided on one main surface of the inorganic layer structure 106 which is not associated to a venting hole 130 and/or vertical through connection 120.

Figure 4 shows a cross-sectional view of a precursor or an element of a component carrier 100 as an exemplary embodiment of the present invention. The precursor or the element of the component carrier 100 comprises an inorganic layer structure 106 comprising at least one vertical through connection 120, at least one venting hole 130 and a temporary mask 140 as shown in Figure 3. Additionally, the precursor or the element of the component carrier 100 comprises at least one electrically conductive layer structure 104. The at least one electrically conductive layer structure 104 may be provided by vapour deposition process step, for example by a physical vapour deposition process, a chemical vapour deposition process or a wet chemical process. Additionally or alternatively, the at least one electrically conductive layer structure 104 may comprise a galvanic plated structure. Preferably, the at least one electrically conductive layer structure 104 comprises metal, in particular copper. In an example, the at least one electrically conductive layer structure 104 can consist of copper. Preferably, the at least one electrically conductive layer structure 104 may be provided on the exposed surfaces of the inorganic layer structure 106. In particular, the at least one electrically conductive layer structure 104 is provided in the vertical through connection 120 in order to create a metal filled vertical through connection. Preferably, the vertical through connection 120 may be fully filled by the at least one electrically conductive layer structure 104, in particular copper. Additionally or alternatively, the electrically conductive layer structure 104 is in direct contact with the inorganic layer structure 106 and the temporary mask 140. At the portion where the temporary mask 140 is located, the provision of the at least one electrically conductive layer structure 104 creates a protrusion. Additionally, since the venting hole 130 is covered on both extremities by the temporary mask 140, the venting hole 130, in particular at least a portion of the sidewall of the venting hole 130, is free from the electrically conductive layer structure 104. Additionally or alternatively, the venting hole 130, in particular at least a portion of the sidewall of the venting hole 130, may be covered by the at least one electrically conductive layer structure 104.

Figure 5 shows a cross-sectional view of a precursor or an element of a component carrier 100 as an exemplary embodiment of the present invention. The precursor or the element of the component carrier 100 comprises an inorganic layer structure 106 comprising at least one vertical through connection 120, at least one venting hole 130 and at least one electrically conductive layer structure 104. In addition to Figure 4, the temporary mask 140 is fully removed. Additionally or alternatively, the portion of the electrically conductive layer structure 104, which was protruding out of at least one main surface of the inorganic layer structure 106, is removed. This may be done by a (copper) etching process step in combination with a mask stripping process step. Preferably, the exposed surface of the electrically conductive layer structure 104 located at the main surfaces may be flat and/or may extend perpendicular to stacking direction Z. Additionally or alternatively, the venting hole 130, in particular both extremities of the venting hole 130, may be exposed to the environment. Thereby, the venting hole 130 is fluidically connecting the environment located at the first main surface of the inorganic layer structure 106 with the environment, in particular the same environment, located at the second main surface of the inorganic layer structure 106 in regard to stacking direction Z. Preferably, the extension of the venting hole 130 may be extended by the thickness of the electrically conductive layer structures 104 in regard to stacking direction Z. The venting hole 130 comprises a sidewall being delimited by the at least one electrically conductive layer structure 104 and the inorganic layer structure 106. Additionally or alternatively, the sidewall of the venting hole 130 comprises at least two portions, in particular a first portion extending parallel to stacking direction and a second portion being inclined to stacking direction Z. Further additionally or alternatively, the sidewall of the venting hole 130 comprises a stepped portion, in particular the stepped portion is located at the extremity of the venting hole 130.

Figure 6 shows a cross-sectional view of a precursor or an element of a component carrier 100 as an exemplary embodiment of the present invention. The precursor or the element of the component carrier 100 comprises an inorganic layer structure 106 comprising at least one vertical through connection 120, at least one venting hole 130 and at least one electrically conductive layer structure 104 as shown in Figure 5. In addition to Figure 5, the exposed electrically conductive layer structure 104 are structured to create electrically conductive traces, in particular copper traces. The electrically conductive traces are located adjacent laterally next to each other on the same vertical level in regard to stacking direction Z. Preferably the respective electrically conductive traces may comprise different width in regard perpendicular to stacking direction Z one to each other. Additionally or alternatively, the electrically conductive traces may be free from direct contact with each other. Additionally, a temporary aid structure 150 is provided. The temporary aid structure 150 may comprise an organic polymeric material, for example a resin material. Preferably, the temporary aid structure 150 may be applied by a lamination process step and/or by a screen printing process step and/or a curtain coating process step. The temporary aid structure 150 is provided laterally between two adjacent electrically conductive layer structures 104, in particular between two adjacent electrically conductive traces. Additionally the temporary aid structure 150 is provided such, that it covers the main surface of the electrically conductive layer structure 104, in particular the electrically conductive traces. Preferably, the temporary aid structure 150 is provided on both exposed surfaces of the inorganic layer structure 106. In the shown Figure 6, one temporary aid structure 150, in this case the top temporary aid structure 150, is structured such that it exposes (one main surface of) the adjacent at least one electrically conductive layer structure 104, in particular at least one electrically conductive trace. The other temporary aid structure 150, in this case the bottom temporary aid structure 150, is not structured and thus prevents the adjacent electrically conductive layer structure 104 from being exposed. The temporary aid structure 150 is in direct contact with the at least one electrically conductive layer structure 104, in particular the main surface and/or the sidewall of the at least one electrically conductive layer structure 104, and the inorganic layer structure 106, in particular the main surface of the inorganic layer structure 106.

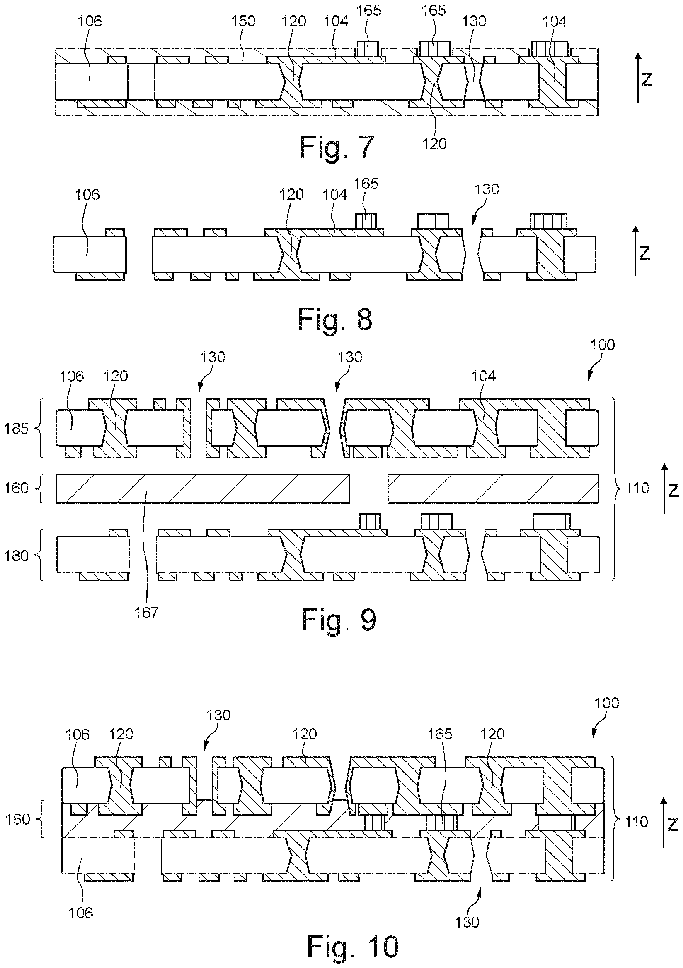

Figure 7 shows a cross-sectional view of a precursor or an element of a component carrier 100 as an exemplary embodiment of the present invention. The precursor or the element of the component carrier 100 comprises an inorganic layer structure 106 comprising at least one vertical through connection 120, at least one venting hole 130, at least one electrically conductive layer structure 104 and a temporary aid structure 150 as shown in Figure 6. In addition to Figure 6, at least one portion comprising metallic nanostructures and/or microstructures 165 is provided. In particular, the metallic nanostructures and/or microstructures 165 are in direct contact with the at least one electrically conductive layer structure 104. Preferably, the metallic nanostructures and/or microstructures 165 may be in direct contact with the portion of the at least one electrically conductive layer structure 104 which are exposed and/or being free from coverage of the temporary aid structure 150. The metallic nanostructures and/or microstructures 165 protrudes from the main surface of the precursor or the element of the component carrier 100 in regard to stacking direction Z. Additionally or alternatively, the metallic nanostructures and/or microstructures 165 are free from direct contact with the temporary aid structure 150. Optionally, the metallic nanostructures and/or microstructures 165 may be in direct contact with the temporary aid structure 150. In an example, the metallic nanostructures and/or microstructure 165 may comprise copper nanowires. Additionally or alternatively, the metallic nanostructures and/or microstructures 165 may comprise sinter paste and/or solder paste. In an example, the metallic nanostructures and/or microstructures 165 may be provided by a galvanic plating process step. Additionally or alternatively, the metallic nanostructures and/or microstructures 165 may be provided by a (screen or three dimensional) printing process step and/or a dispensing process step.

Figure 8 shows a cross-sectional view of a precursor or an element of a component carrier 100 as an exemplary embodiment of the present invention. The precursor or the element of the component carrier 100 comprises an inorganic layer structure 106 comprising at least one vertical through connection 120, at least one venting hole 130, at least one electrically conductive layer structure 104 and metallic nanostructures and/or microstructures 165 as shown in Figure 7. In addition to Figure 7, the temporary aid 150 structure is fully removed. Thereby, the inorganic layer structure 106 and/or the electrically conductive layer structure 104 and/or the venting hole 130 are exposed. As can be seen by Figure 8, the metallic nanostructures and/or microstructures 165 are provided in the central portion of the at least one electrically conductive layer structure 104, in particular the electrically conductive trace, in regard to direction perpendicular to stacking direction Z. Additionally or alternatively, the metallic nanostructures and/or microstructures 165 may be provided in the peripheral portion of the at least one electrically conductive layer structure 104, in particular the electrically conductive trace, in regard to direction perpendicular to stacking direction Z.

Figure 9 shows an exploded cross-sectional view of a component carrier 100 according to an exemplary embodiment of the present invention. The component carrier 100 comprises three constituents of the stack 110. A first constituent 180 is identical to the precursor or element of the component carrier 100 shown in Figure 8. A second constituent 185 is similar to the precursor or element of the component carrier 100 shown in Figure 8. Similar to the precursor or element of the component carrier 100 shown in Figure 8, the second constituent 185 comprises an inorganic layer structure 106 comprising at least one vertical through connection 120 and at least one venting hole 130. Additionally the inorganic layer structure 106 of the second constituent 185 comprises at least one electrically conductive layer structure 104. In comparison to Figure 8, the second constituent 185 is free of metallic nanostructures and/or microstructures 165. Optionally the second constituent 185 may comprise metallic nanostructures and/or microstructures 165 in direct contact with the at least one electrically conductive layer structure 104 as shown in Figure 8. Additionally, the second constituent 185 comprises coated sidewalls of the venting holes 130. The coating of the sidewalls comprises electrically conductive material, in particular material composing the at least one electrically conductive layer structure 104, more in particular copper. The sidewalls of the venting hole 130 is fully covered with copper. Thereby the coated sidewalls are electrically connecting the electrically conductive layer structure 104 exposed on one main surface/side of the second constituent 185, for example the top side, with the electrically conductive layer structure 104 exposed on a second main surface/side of the second constituent 185, for example the bottom side. Additionally or alternatively, only a portion of the sidewall of the venting hole 130 may be covered by copper. Thus, the venting hole 130 is fluidically connecting the environment located at the first main surface one main surface of the second constituent 185 with the environment located at opposed second main surface of the second constituent 185, in particular by at least one channel which is free from solid and/or liquid material in regard to stacking direction Z. Optionally, the venting hole 130 may be at least partially filled with an organic material, for example a plug paste. The third constituent is composed of a connection structure 160, in particular an inorganic connection layer structure 167. The connection structure 160, in particular the inorganic connection layer structure 167 comprises meta silicate, in particular lithium meta silicate. Additionally or alternatively, the connection structure 160 may comprise organic material, in particular organic polymeric material. In the shown Figure 9, the inorganic connection layer structure 167 comprises a through hole. Alternatively, the inorganic connection layer structure 167 may comprise a plurality of through holes or may be free of a through hole. The architecture of the stack 110 is such, that the first constituent 180, the second constituent 185 and the inorganic connection layer structure 167 are stacked one above the other in regard to tacking direction Z. Additionally, the inorganic connection layer structure 167 is located between the first constituent 180 and the second constituent 185. The first constituent 180 is located such, that the metallic nanostructures and/or microstructures 165 are facing the inorganic connection layer structure 167 and/or the second constituent 185. In particular the architecture of the stack 110 is such, that the metallic nanostructures and/or microstructure 165 of the first constituent 180 are located such, that the metallic nanostructures and/or microstructure 165 are facing the exposed electrically conductive layer structure 104 of the second constituent 185. In an example, the metallic nanostructures and/or microstructure 165 are located such, that the metallic nanostructures and/or microstructure 165 are inside the circumference of the though hole of the inorganic connection layer structure 167 (when considering a top view). This may be advantageous, when the metallic nanostructures and/or microstructures comprise 165 sinter paste and/or solder paste. In another example, the metallic nanostructures and/or microstructure 165 are located such, that the metallic nanostructures and/or microstructure 165 are outside the circumference of the though hole of the inorganic connection layer structure 167 (when considering a top view). This may be advantageous, when the metallic nanostructures and/or microstructures comprise 165 copper nanowires, since the copper nanowires may displace the inorganic connection layer structure 167 during manufacturing.

Figure 10 shows a cross-sectional view of a component carrier 100 according to an exemplary embodiment of the present invention. The component carrier 100, is created by connecting to first constituent of the stack 180, the second constituent of the stack 185 and the connection structure 160, in particular to the inorganic connection layer structure 167. This may be done by applying elevated temperatures, for example larger than 70 °C, and/or elevated pressure, for example larger than 1.5 bar. The first constituent of the stack 180 and the second constituent of the stack 185 are displaced one to each other in regard to stacking direction Z. Additionally or alternatively, the first constituent of the stack 180 and the second constituent of the stack 185 are free from direct contact one to each other. The component carrier 100 comprises a stack 110 comprising a plurality of electrically conductive layer structures 104 and at least two inorganic layer structures 106. Additionally the component carrier 100 comprises a connection structure 160 configured for connecting the at least two inorganic layer structures 106, said connection structure 160 comprising metallic nanostructures and/or microstructures 165 configured for connecting at least two of the plurality of electrically conductive layer structures 104. The connection structure 160 comprises the inorganic connection layer structures 167 and the metallic nanostructures and/or microstructures 165. Additionally, the connection structure 160 is in direct contact with at least one of the plurality of electrically conductive layer structures 104, in particular the connection structure 160 is in direct contact with the electrically conductive layer structure 104 of the first constituent of the stack 180 and the electrically conductive layer structure 104 of the second constituent of the stack 185. Additionally or alternatively, the connection structure 160 is in direct contact with at least one inorganic layer structure 106, in particular the inorganic layer structure 106 of the first constituent of the stack 180 and the inorganic layer structure 160 of the second constituent of the stack 185. The metallic nanostructures and/or microstructures 165 are in direct contact with the electrically conductive layer structure 104 of the first constituent of the stack 180 and the electrically conductive layer structure 104 of the second constituent of the stack 185. In other words, at least one of the plurality of electrically conductive layer structures 104 is connected to the metallic nanostructures and/or microstructures 165. The metallic nanostructure and/or microstructures 165 are provided such that the metallic nanostructure and/or microstructures 165 are located in a central portion of an adjacent electrically conductive layer structure 104 in regard being perpendicular to stacking direction Z. Additionally or alternatively, the metallic nanostructure and/or microstructures 165 are provided such that the metallic nanostructure and/or microstructures 165 are located in a peripheral portion of an adjacent electrically conductive layer structure 104 in regard being perpendicular to stacking direction Z. In an example, the metallic nanostructure and/or microstructures 165 are provided such that the metallic nanostructure and/or microstructures 165 are located in a central portion of an adjacent electrically conductive layer structure 104 in regard being perpendicular to stacking direction Z and the metallic nanostructure and/or microstructures 165 are provided such that the metallic nanostructure and/or microstructures 165 are located in a peripheral portion of another adjacent electrically conductive layer structure 104 in regard being perpendicular to stacking direction Z, thereby directly connecting the two electrically conductive layer structure 104 being in direct contact with the metallic nanostructure and/or microstructures 165. In another example, the metallic nanostructure and/or microstructures 165 are provided such that the metallic nanostructure and/or microstructures 165 are located in a central portion of an adjacent electrically conductive layer structure 104 in regard being perpendicular to stacking direction Z and the metallic nanostructure and/or microstructures 165 are provided such that the metallic nanostructure and/or microstructures 165 are located in a central portion of another adjacent electrically conductive layer structure 104 in regard being perpendicular to stacking direction Z, thereby directly connecting the two electrically conductive layer structure 104 being in direct contact with the metallic nanostructure and/or microstructures 165. Still in a further example, the metallic nanostructure and/or microstructures may be provided such that the metallic nanostructure and/or microstructures are located in a peripheral portion of an adjacent electrically conductive layer structure in regard being perpendicular to stacking direction Z and the metallic nanostructure and/or microstructures may be provided such that the metallic nanostructure and/or microstructures are located in a peripheral portion of another adjacent electrically conductive layer structure in regard being perpendicular to stacking direction Z, thereby directly connecting the two electrically conductive layer structure being in direct contact with the metallic nanostructure and/or microstructures (not shown).

The plurality of electrically conductive layer structures 104 of the component carrier 100 comprises at least one, in particular a plurality of, vertical through connection 120, in particular metal filled vertical through connections, passing through the entire thickness of the one of the at least two inorganic layer structures 106. The component carrier 100 comprises a stack 110 comprising at least one electrically conductive layer structure 104 and at least one inorganic layer structure 106. Additionally, the component carrier 100 comprises a connection structure 160 provided on one surface of the at least one inorganic layer structure 106, said connection structure 160 comprising a material comprising a volatile portion released, wherein said at least one inorganic layer structure 106 comprises at least one venting hole 130 connected on the surface of the at least one inorganic layer structure 106 where the connection structure 160 is provided. Preferably, the volatile portion may be released during the hardening of the material of the connection structure 160. In an example, the volatile portion may comprise volatile and/or gaseous material, for example water vapour. The connection structure 160, in particular the inorganic connection layer structure 167, extends/protrudes into at least one venting hole 130, thereby at least partially filling the volume of the venting hole 130. Optionally, the venting hole 130 may not be filled by the connection structure 160, in particular the inorganic connection layer structure 167. This may be related to the viscosity of the material of the connection structure 160, which may be too viscous to fully fill and/or enter the venting hole 130. Each of the at least two inorganic layer structures 106 of the stack 110 comprises at least one, in particular a plurality of, vertical through connections 120 passing through the entire thickness of the respective inorganic layer structures 106, in particular the plurality of vertical through connections 120 passing through one first inorganic layer structure 106 is misaligned with the respective vertical through connections 120 passing through the other second inorganic layer structure 106. Additionally or alternatively, each of the at least two inorganic layer structures 106 of the stack 110 comprises at least one, in particular a plurality of, venting holes 130 passing through the entire thickness of the respective inorganic layer structures 106, in particular the plurality of venting holes 130 passing through one first inorganic layer structure 106 is misaligned with the respective venting holes 130 passing through the other second inorganic layer structure 106. The amount of vertical through connections 120 passing through the first inorganic layer structure 106 is different than the amount of vertical through connections 120 passing through the second inorganic layer structure 106. Additionally or alternatively, the extension of at least one vertical through connection 120 passing through the first inorganic layer structure 106 is different than the extension of at least one vertical through connection 120 passing through the second inorganic layer structure 106. The at least two of the plurality of electrically conductive layer structures 104, the at least two inorganic layer structures 106, the connection structure 160 and the metallic nanostructures and/or microstructures 165 form a core structure, in particular an inorganic core structure, more in particular an inorganic multilayer core structure.

Figure 11 shows a cross-sectional view of a component carrier 100 according to an exemplary embodiment of the present invention. In addition to the component carrier shown in Figure 10, the stack 110 comprises at least one, in particular two, electrically insulating layer structure 102, in particular at least one organic electrically insulating layer structure. One of the electrically insulating layer structures 102 is located on one side of one of the at least two inorganic layer structures 106, in particular of the core structure. The second electrically insulating layer structure 102 is located on the other side of one of the at least two inorganic layer structures 106, in particular of the core structure. At least one electrically insulating layer structure 102 is protruding/extending into at least one venting hole 130, thereby at least partially filling (the volume of) the venting hole 130. As can be seen by Figure 11, at least one venting hole 130 is partially filled with the connection structure 160, is at least partially filled with the electrically insulating layer structure 102 and is at least partially filled with gas or a vacuum may be provided inside the venting hole 130. Additionally or alternatively, the venting hole 130 may filled, in particular fully filled, by the connection structure 160, in particular the meta silicate, and/or the electrically insulating layer structure 102 (see Figure 12). Still referring to Figure 11, in an example, the electrically insulating layer structure 102 may comprise organic material, in particular organic polymeric material. In another example, the electrically insulating layer structure 102 may comprise epoxy resin and/or poly (meth)acrylate. A further electrically conductive layer structure 104 is located at one main surface of at least one of the at least two inorganic layer structures 106, in particular of the core structure, in particular in contact with at least one electrically insulating layer structure 102 and/or the other electrically insulating layer structures 102. The stack 110 thereby is enlarged by the further electrically conductive layer structures 104 and the electrically insulating layer structures 102.

Figure 12 shows a cross-sectional view of a component carrier 100 according to an exemplary embodiment of the present invention. In addition to the component carrier shown in Figure 11, the stack 110 comprises a plurality of electrically insulating layer structures 102 located on one side of one of the at least two inorganic layer structures 106, in particular of the core structure. Additionally, another plurality of electrically insulating layer structures 102 is located on the other side of one of the at least two inorganic layer structures 106, in particular of the core structure. In particular, the amount of electrically insulating layer structures 106 provided on the first main surface of one of the at least two inorganic layer structures 106, in particular of the core structure, is different than the amount of electrically insulating layer structures 106 provided on the second main surface of one of the at least two inorganic layer structures 106, in particular of the core structure. Additionally or alternatively, the amount of electrically insulating layer structures 106 provided on the first main surface of one of the at least two inorganic layer structures 106, in particular of the core structure, may be the same as the amount of electrically insulating layer structures 106 provided on the second main surface of one of the at least two inorganic layer structures 106, in particular of the core structure. A plurality, of further electrically conductive layer structures 104 is located at one main surface of at least one of the at least two inorganic layer structures 106, in particular of the core structure, in particular in contact with at least one of the plurality of electrically insulating layer structures 102 and/or the other plurality of electrically insulating layer structures 102. At least one of the plurality of further electrically conductive layer structure 104 is provided between two of the plurality of electrically insulating layer structures 102. Additionally or alternatively, at least one of the plurality of further electrically conductive layer structures 104 is provided between two of the other plurality of electrically insulating layer structure 102. The amount of further electrically conductive layer structures 104, which are in contact with at least one of the plurality of electrically insulating layer structures 102 is different than the amount of further electrically conductive layer structures 104, which are in contact with at least one of the plurality of the other electrically insulating layer structures 102. The further electrically conductive layer structures 104 are vertically connected with each other by a plurality of further vertical through connections, in particular metal filled vertical through connections 122. The extension perpendicular to stacking direction Z and/or the extension parallel to stacking direction Z of a further vertical through connection 122 is different than the extension perpendicular to stacking direction Z and/or the extension parallel to stacking direction Z of a vertical through connection 120 and/or is different than the extension perpendicular to stacking direction Z and/or the extension parallel to stacking direction Z of a venting hole 130. Additionally or alternatively, the extension perpendicular to stacking direction Z and/or the extension parallel to stacking direction Z of a further vertical through connection 122 may be the same as the extension perpendicular to stacking direction Z and/or the extension parallel to stacking direction Z of a vertical through connection 120 and/or is the same as extension perpendicular to stacking direction Z and/or the extension parallel to stacking direction Z of a venting hole 130 (see also Figure 11). Still referring to Figure 12, the amount of further electrically conductive layer structures 104, which are in contact with at least one of the plurality of electrically insulating layer structures 102 is different than the amount of further electrically conductive layer structures 104, which are in contact with at least one of the plurality of the other electrically insulating layer structures 102. Additionally or alternatively, the further electrically conductive layer structure 104 is connected to the electrically conductive layer structure 104. The plurality of further electrically conductive layer structures 104 and the plurality of electrically insulating layer structures 102 form a redistribution layer structure provided at the first main surfaces of the at least two inorganic layer structures 106, in particular of the core structure. Additionally or alternatively, the plurality of further electrically conductive layer structures 104 and the other plurality of electrically insulating layer structures 102 form a second redistribution structure provided at the opposed second main surfaces of the at least two inorganic layer structures 106, in particular of the core structure. The two redistribution structures are configured to impart to the component carrier an asymmetric structure. At least one of the plurality of electrically conductive layer structures 104 comprises an element of an antenna structure 190 and/or forms an antenna structure. Additionally or alternatively, at least one of the plurality, in particular of the at least two of the plurality, of electrically conductive layer structures 104 comprises a stripline. Further additionally or alternatively, the stack 110 comprises a shielding structure 195. Preferably, at least one of the plurality of electrically conductive layer structures 104 comprises and/or forms the shielding structure 195. In particular, the shielding structure 195 is located on one surface of one of the at least two inorganic layer structures 106. Additionally or alternatively, the shielding structure 195 is located on the opposed surface of at least one, in particular on both, of the inorganic layer structure 106 where the connection structure 160 is provided. Further additionally or alternatively, the shielding structure 195 is free from direct contact with the connection structure 160. Optionally, at least one of the at least two inorganic layer structures 106 may comprise the shielding structure 195. In a preferred embodiment, the component carrier 100 comprises at least one component 170. The component carrier 100 comprises the at least one component 170 provided in a cavity located in at least one of the at least two inorganic layer structures 106. Preferably, the at least one component 170 is connected to the antenna structure 190. In an example, the component 170 is in direct contact with an electrically conductive layer structure 104, wherein the electrically conductive layer structure 104 is located at one main surface of the inorganic layer structure 104. In another example, the component 170 is connected the a further electrically conductive layer structure 104 by a further vertical through connection 122. Additionally or alternatively, the component carrier 100 comprises at least one further component 170. In an example, the at least one further component 170 is provided at one main surface of the stack 110. In another example, the at least one further component 170 may be embedded in the stack (not shown). Additionally or alternatively, the at least one further component 170 is connected to the further electrically conductive layer structure 104. The venting hole 130 has a lateral and/or radial extension being different, in particular smaller, than the lateral and/or radial extension of the vertical through connection 120 passing through the entire thickness of one of the at least two inorganic layer structure 106. Additionally or alternatively, the venting hole 130 is filled, in particular fully filled, by the connection structure 160, in particular the meta silicate, and/or the electrically insulating layer structure 102. The ratio of the electrically insulating layer structure 102 filling the volume of the venting hole 130 is larger than the ratio of the connection structure 160 filling the volume of the same venting hole 130. In an example, the ratio of the electrically insulating layer structure 102 filling the volume of the venting hole 130 may be larger than 60%, in particular 70%. The sidewall of the venting hole 130 is in direct contact with the connection structure 160 and the electrically insulating layer structure 102. The venting hole 130 is located on one side, in particular one main surface, of the connection structure 160. As an exemplary example, at least one vertical through connection 120 has a frustoconical shape. At least one venting hole may have a frustoconical shape (not shown).

It should be noted that the term "comprising" does not exclude other elements or steps and the "a" or "an" does not exclude a plurality. Also, elements described in association with different embodiments may be combined.

Implementation of the invention is not limited to the preferred embodiments shown in the figures and described above. Instead, a multiplicity of variants is possible which use the solutions shown and the principle according to the invention, whose scope is defined by the appended claims.

### List of Reference Signs

- 100: component carrier
- 102: electrically insulating layer structure
- 104: electrically conductive layer structure
- 106: inorganic layer structure
- 110: stack
- 120: vertical through connection, metal filled vertical through connection
- 122: further vertical through connection, metal filled vertical through connection
- 130: venting hole
- 140: temporary mask
- 150: temporary aid structure
- 160: connection structure
- 165: metallic nanostructures and/or micro structures
- 167: inorganic connection layer structure
- 170: component; further component
- 180: first constituent of the stack
- 185: second constituent of the stack
- 190: element of antenna structure
- 195: shielding structure

- Z: thickness direction

## Claims

1. A component carrier (100) comprising:
a stack (110) comprising a plurality of electrically conductive layer structures (104) and at least two inorganic layer structures (106);
a connection structure (160) configured for connecting the at least two inorganic layer structures (106), said connection structure (106) comprising metallic nanostructures and/or microstructures (165) configured for connecting at least two of the plurality of electrically conductive layer structures (104).

2. A component carrier (100) according to claim 1,
wherein the connection structure (160) comprises an inorganic connection layer structure (167),
in particular wherein the connection structure (160) comprises meta silicate, in particular lithium and/or potassium meta silicate.

3. A component carrier (100) according to claim 1 or 2,
wherein at least one, in particular the at least two, inorganic layer structures (106) is made of glass.

4. A component carrier (100) according to one of the claims 1 to 3,
wherein at least one, in particular the at least two, inorganic layer structures (106) comprises at least one venting hole (122).

5. A component carrier (100) according to one of the claims 1 to 4,
wherein the metallic nanostructures and/or microstructures (165) comprises nanowires and/or a conductive paste, in particular a sinter paste and/or solder paste.

6. A component carrier (100) according to one of the claims 1 to 5,
wherein at least one of the plurality of electrically conductive layer structures (104) is connected to the metallic nanostructures and/or microstructures (165),
in particular wherein the plurality of electrically conductive layer structures (104) comprises at least one, in particular a plurality of, vertical through connection (120) passing through the entire thickness of the one of the at least two inorganic layer structures (106).

7. A component carrier (100) according to one of the claims 1 to 6, wherein at least one of the plurality of electrically conductive layer structures (104) comprises an element of an antenna structure (190) and/or forms an antenna structure.

8. A component carrier (100) according to one of the claims 1 to 7,
wherein the stack (110) comprises a shielding structure (195), in particular wherein at least one of the plurality of electrically conductive layer structures (104) comprises and/or forms the shielding structure (195).

9. A component carrier (100) according to claim 8,
wherein the shielding structure (195) is located on the opposed surface of at least one, in particular on both, of the inorganic layer structure (106) where the connection structure (160) is provided.

10. A component carrier (100) according to one of the claims 1 to 9,
wherein the at least two of the plurality of electrically conductive layer structures (104), the at least two inorganic layer structures (106), the connection structure (160) and the metallic nanostructures and/or microstructures (165) form a core structure, in particular an inorganic core structure, more in particular an inorganic multilayer core structure.

11. A component carrier (100) according to one of the claims 1 to 10, wherein the stack (110) comprises at least one electrically insulating layer structure (102), in particular at least one organic electrically insulating layer structure,
in particular wherein at least one, in particular a plurality, of electrically insulating layer structures (102) is located on one side of one of the at least two inorganic layer structures (106), in particular of the core structure,
more in particular wherein another at least one, in particular a plurality, of electrically insulating layer structures (102) is located on the other side of one of the at least two inorganic layer structures (106), in particular of the core structure.

12. A method of manufacturing a component carrier (100), the method comprising:
providing a stack (110) comprising a plurality of electrically conductive layer structure (104) and at least two inorganic layer structure (106);
providing a connection structure (160) configured for connecting the at least two inorganic layer structure (106), said connection structure (160) comprising metallic nanostructures and/or microstructures (165) configured for connecting at least two of the plurality of electrically conductive layer structures (104).

13. A method of manufacturing a component carrier (100) according claim 12 comprising:
connecting the first inorganic layer structure (106) to the second inorganic layer structure (106) by the connection structure (160) and/or connecting the first inorganic layer structure (106) to the second inorganic layer structure (106) by metallic nanostructures and/or microstructures (165).

14. A component carrier (100) comprising:
a stack (110) comprising at least one electrically conductive layer structure (104) and at least one inorganic layer structure (106);
a connection structure (160) provided on one surface of the at least one inorganic layer structure (106), said connection structure (160) comprising a material suitable to have contained a volatile portion released during the hardening of the material,
wherein said at least one inorganic layer structure (106) comprises at least one venting hole (130) connected on the surface of the at least one inorganic layer structure (106) where the connection structure (160) is provided.

15. A component carrier (100) according to claim 4 or14,
wherein the venting hole (130) is filled, in particular fully filled, by the connection structure (160), in particular the meta silicate, and/or the electrically insulating layer structure (102).
